# EUROPÄISCHE PATENTSCHRIFT

(11) **EP 2 887 778 B1**
(45) Veröffentlichungstag und Bekanntmachung des Hinweises auf die Patenterteilung: **08.06.2022**
(21) Anmeldenummer: 14197651.4
(22) Anmeldetag: 12.12.2014
(51) Int. Cl.: H05K 1/02, H05K 1/18

(54) **Flexible Leiterplatte mit Kühlkörper und Verfahren zu deren Herstellung**
Flexible circuit board with heat sink and method of manufucturing thereof
Carte de circuit souple avec dissipateur thermique et procédé pour sa fabrication

(30) Priorität: 20.12.2013 DE 102013226972
(43) Veröffentlichungstag der Anmeldung: 24.06.2015
(73) Patentinhaber: Zumtobel Lighting GmbH, 6850 Dornbirn (AT)
(72) Erfinder: Favarolo, Angelo, 88239 Wangen (DE); Schwärzler, Erich, 6941 Langenegg (AT)
(74) Vertreter: Kiwit, Benedikt

(56) Entgegenhaltungen:
- EP-A1- 2 396 158
- DE-A1- 10 234 995
- DE-U1- 20 316 433
- US-A1- 2007 121 326
- US-A1- 2007 229 753
- US-A1- 2012 230 031
- US-B1- 6 726 502
- US-B1- 7 339 268

## Beschreibung

### 1. Gebiet der Erfindung

Die vorliegende Erfindung betrifft ein Verfahren zur Herstellung einer Leiterplatten-Anordnung, sowie eine (dadurch hergestellte) Leiterplatten-Anordnung und ein Beleuchtungsmittel mit einer solchen Leiterplatten-Anordnung.

### 2. Hintergrund

Aus dem Stand der Technik sind verschiedene Ausführungsformen flexibler Leiterplatten, insbesondere für die Aufnahme von Leuchtdioden, mit leitenden Bereichen, wie zum Beispiel Leiterbahnen und Anschlusspads zur Aufnahme von Leuchtdioden, bekannt. Derartige Leiterplatten werden üblicherweise aus einem Kunststoff hergestellt, der über eine entsprechend hohe Flexibilität verfügt, beispielsweise Polyimid, Polyethylennaphtalat, Polyester oder FR-4.

Diese Materialien weisen generell jedoch nur relativ geringe Wärmeleitfähigkeiten auf, so dass die durch die Leuchtdioden anfallende Wärme durch das Leiterplattenmaterial selbst nur ungenügend abgeführt werden kann. Lediglich durch die leitenden Bereiche, die meist aus einer Kupferlegierung gebildet werden, und damit eine hohe Wärmeleitfähigkeit aufweisen, erfolgt eine Wärmeabfuhr. Diese ist jedoch in der Praxis nicht ausreichend, um die Wärme von den Leuchtdioden zufriedenstellend abzuführen. Dies ist insoweit problematisch, als dass die Lichtausbeute und die Lebensdauer einer Leuchtdiode stark temperaturabhängig sind. In der Praxis werden daher an der Rückseite der flexiblen Leiterplatte Kühlkörper angeordnet, die aus Materialien mit hoher Wärmeleitfähigkeit bestehen, um dadurch die Wärme möglichst effizient von den Leuchtdioden abzuführen.

Üblicherweise bestehen die Kühlkörper aus einer gut wärmeleitenden Metalllegierung, basierend auf Kupfer oder Aluminium, und werden auf die Rückseite der flexiblen Leiterplatte geklebt oder laminiert. Solche flexiblen Leiterplatten mit aufgeklebten oder auflaminierten metallischen Kühlkörpern sind beispielsweise aus den Druckschriften DE 20 2010 017 532 U1, DE 201 20 770 U1 und DE 199 22 176 A1 bekannt. Die US 2012/0230031 A1 offenbart eine Kabelleuchtenanordnung mit zwei elektrisch isolierten elektrischen Leitern und zumindest einer LED. Die US 6,726,502 B1 offenbart eine Leuchtenvorrichtung mit einem flexiblen Kabel und mehreren Leuchtgeräten. Die US 2007/0121326 A1 offenbart eine Leuchtenvorrichtung mit einer thermischen Umspritzung. Die US 7,339,268 B1 offenbart einen Halbleiter-Die, angebracht auf einem flexiblen Kabel, das eine Wärmesenkenschicht aufweist. Die WO 2010/091873 offenbart ein Verfahren zur Herstellung einer LED-Leuchte, bei dem wenigstens ein LED-Band zur Ausbildung eines Gehäuses allseitig mit wenigstens einer Vergussmasse vergossen wird. Die DE 203 16 433 U1 offenbart ein elektrisches Bauelement, mit einer Leiterplatte, die mit mindestens einer Leuchtdiode bestückt und von einem transparenten Spritzgusskörper umschlossen ist. Die US 2007/0229753 A1 offenbart eine Wärmeabfuhrstruktur eines Hintergrundbeleuchtungsmoduls, aufweisend eine Leiterplatte und ein wärmeleitendes Element.

Das Anbringen des Kühlkörpers an der flexiblen Leiterplatte durch ein Kleben oder Laminieren erfordert dabei die Durchführung mehrerer Verfahrensschritten, insbesondere: Aufbringen geeigneter Klebesubstanzen auf die flexible Leiterplatte bzw. auf den Kühlkörper, Aufbringen geeigneter Haftvermittler, Positionieren der flexiblen Leiterplatte auf dem Kühlkörper, Aushärten des Klebers, etc.

Neben diesem relativ hohen Aufwand zur Verbindung einer flexiblen Leiterplatte mit einem Kühlkörper (u.a. aufgrund der Flexibilität und Form der flexiblen Leiterplatte), ist darüber hinaus die damit erreichte thermische Kopplung der flexiblen Leiterplatte mit dem Kühlkörper häufig nicht optimal, da die notwendigerweise vorzusehenden Klebe-, Haftvermittler- und/oder Harzschichten die thermische Kopplung der flexiblen Leiterplatte mit dem Kühlkörper nachteilig beeinflussen.

Ausgehend von diesem Stand der Technik stellt sich die vorliegende Erfindung die Aufgabe, ein Verfahren zur Herstellung einer Leiterplatten-Anordnung mit einer flexiblen Leiterplatte und einem Kühlkörper anzugeben, bei dem die oben genannten Nachteile des Standes der Technik ausgeräumt bzw. vermindert werden.

Insbesondere stellt sich die vorliegende Erfindung die Aufgabe, ein Verfahren bereitzustellen, mit dem eine Leiterplatten-Anordnung mit einer flexible Leiterplatte und einem Kühlkörper möglichst einfach bereitgestellt werden kann, ohne dabei die im Stand der Technik im Zusammenhang mit einem Kleben oder Laminieren notwendigen Verfahrensschritte durchführen zu müssen. Darüber hinaus soll eine optimale thermische Kopplung zwischen der flexiblen Leiterplatte und dem Kühlkörper bereitgestellt werden.

Diese und andere Aufgaben, die beim Lesen der folgenden Beschreibung noch genannt werden oder vom Fachmann erkannt werden können, werden durch den Gegenstand der unabhängigen Ansprüche gelöst. Die abhängigen Ansprüche bilden den zentralen Gedanken der vorliegenden Erfindung in besonders vorteilhafter Weise weiter.

### 3. Ausführliche Beschreibung der Erfindung

Das erfindungsgemäße Verfahren zur Herstellung einer Leiterplatten-Anordnung nach Anspruch 1 umfasst dabei unter anderem die folgenden Schritte:
- Bereitstellen zumindest einer flexiblen Leiterplatte, umfassend (elektrisch und/oder thermisch) leitende Bereiche, nämlich Leiterbahnen und/oder elektrische Kontaktierungen (beispielsweise Anschlusspads für Leuchtdioden);
- Bereitstellen eines Vergusswerkzeugs (insbesondere eines Spritzguss- oder Druckgusswerkzeugs), das zumindest eine Aufnahme für die zumindest eine flexible Leiterplatte und zumindest eine Gusskavität zur Ausbildung eines Kühlkörpers umfasst;
- Einlegen der flexiblen Leiterplatte in die Aufnahme des Gusswerkzeugs; und
- Einspritzen bzw. Einbringen von Kunststoff in das Gusswerkzeug, so dass der Kühlkörper an zumindest einer Seite der eingelegten flexiblen Leiterplatte gebildet wird.

Das erfindungsgemäße Verfahren schlägt also vor, den Kühlkörper unmittelbar an einer Seite, vorzugsweise wenigstens an der Rückseite, der flexible Leiterplatte durch ein (Spritz- oder Druck-)Gussverfahren anzuformen, so dass sich eine im Wesentlichen integral ausgebildete Leiterplatten-Anordnung ergibt.

Durch die vorgeschlagene unmittelbare Anformung des Kühlkörpers an der flexiblen Leiterplatte bzw. das Integrieren der flexiblen Leiterplatte direkt in einem thermisch leitfähigen Kunststoffteil, können die im Stand der Technik notwendigen Verfahrensschritte im Zusammenhang mit dem Aufkleben bzw. dem Auflaminieren der flexiblen Leiterplatte auf dem Kühlkörper vermieden werden. Das erfindungsgemäße Verfahren stellt somit eine wesentlich einfachere, schnellere und damit kostengünstigere Möglichkeit dar, eine Leiterplatten-Anordnung mit einer flexiblen Leiterplatte und einem Kühlkörper bereitzustellen.

Folglich besteht auch keine Notwendigkeit mehr, die im Zusammenhang mit dem Aufkleben bzw. Auflaminieren notwendigen Klebe-, Haftvermittler- und/oder Harzschichten vorzusehen, so dass sich demgemäß auch keine nachteilige Beeinflussung der thermischen Kopplung der flexiblen Leiterplatte mit dem Kühlkörper mehr ergibt. Allerdings ist darauf hinzuweisen, dass es in manchen Anwendungen dennoch von Vorteil sein kann, derartige Schichten vorzusehen.

Neben den bereits oben genannten Vorteilen, kann somit auch eine wesentlich höhere thermische Kopplung der flexiblen Leiterplatte mit dem Kühlkörper erzielt werden, da auch auf die im Stand der Technik notwendigerweise vorzusehenden Klebe-, Haftvermittler- und/oder Harzschichten verzichtet werden kann.

Ein weiterer Vorteil des erfindungsgemäßen Verfahrens besteht darin, dass auch flexible Leiterplatten, die eine komplexere Form einnehmen sollen, wie beispielsweise häufig bei Einbau in Kfz-Anwendungen, auf einfache Weise mit einem geometrisch angepassten Kühlkörper versehen (beispielsweise hinterspritzt) werden können, um eine Funktionskombination von Platinenträger mit Kühlkörper zu bilden. Auf diese Weise können kosteneffizient auch Serienteile gefertigt werden.

Vorzugsweise umfasst der Kunststoff einen Füllstoff zur Erhöhung der thermischen Leitfähigkeit. Als Füllstoff zur Erhöhung der thermischen Leitfähigkeit des Kühlkörpers kommen dabei alle Materialien in Betracht, die eine hohe thermische Leitfähigkeit aufweisen und die dem (thermoplastischen) Kunststoff beigemengt werden können. Insbesondere sind folgende Materialien als Füllstoff für den Kunststoff besonders gut geeignet: Kupfer, Aluminium, Graphit, Ruß, Al2O3, AlN, BN, etc. Derartige Kühlkörper ermöglichen sehr gute thermische Eigenschaften, ähnlich derer von Aluminiumoxid und deutlich besser als die von CEM-3 oder FR-4 Leiterplatten.

Darüber hinaus besteht die Möglichkeit, den Füllstoff je nach Bedarf in unterschiedlichen Mengenverhältnissen dem Kunststoff beizumengen und dadurch die jeweilige Wärmeleitfähigkeit des Kühlkörpers an verschiedene Bedingungen anzupassen, wie beispielsweise an die anfallende Wärmemenge oder an das zur Verfügung stehende Kühlkörpervolumen. Steht beispielsweise nur ein begrenztes Volumen für den Kühlkörper zur Verfügung, kann durch einen höheren Füllstoffeintrag die thermische Leitfähigkeit des Kunststoffs und damit der Wärmeabtransport erhöht werden.

Vorzugsweise wird durch den Füllstoff, der dem Kunststoff beigemengt wird, eine thermische Leitfähigkeit zwischen 1 und 15 W/mK, bevorzugt zwischen 2 und 10 W/mK und besonders bevorzugt zwischen 4 und 6 W/mK eingestellt. In der Praxis hat sich gezeigt, dass für die meisten Anwendungen eine thermische Leitfähigkeit zwischen 4 und 6 W/mK geeignet ist.

Vorzugsweise wird die flexible Leiterplatte bereits vor dem Einlegen in die Aufnahme des Gusswerkzeugs mit elektronischen Bauteilen, wie insbesondere Leuchtdioden, bestückt. Eine solche Vorgehensweise ist fertigungstechnisch besonders vorteilhaft, da die flexiblen Leiterplatten automatisiert beispielsweise mit Leuchtdioden bestückt werden können, solange die flexiblen Leiterplatten noch nicht mit einem Kühlkörper verbunden sind. Dies führt wiederum zu einer erheblichen Kostenreduzierung und Beschleunigung des Herstellungsverfahrens, da die Leuchtdioden nicht manuell bzw. durch einen ggf. noch zu entwickelnden Automatisierungsschritt bestückt werden müssen.

Durch die unmittelbare Verbindung der flexiblen Leiterplatte mit dem darauf vorgesehenen bzw. angespritzten Kühlkörper und dem damit einhergehenden effizienten Wärmeabtransport besteht darüber hinaus die Möglichkeit, die flexiblen Leiterplatten mit sogenannten Hochleistungs-Leuchtdioden zu bestücken, bei denen aufgrund der hohen Leistungsaufnahme erhebliche Wärmemengen anfallen und abzuführen sind.

Unter Hochleistungs-Leuchtdioden bzw. sogenannten High-Power-Leuchtdioden sind vorliegend Leuchtdioden zu verstehen, die zumindest eine Leistungsaufnahme von 300 mW aufweisen, typischerweise eine Leistungsaufnahme zwischen 1 und 3 W.

Vorzugsweise ist der Kühlkörper elektrisch isolierend ausgebildet, d.h. es wird, soweit erforderlich, ein Füllstoffeintrag gewählt, der nicht ausreichend ist, um einen damit gebildeten Kühlkörper elektrisch leitfähig zu machen.

Die leitenden Bereiche der flexiblen Leiterplatte, die Leiterbahnen und z.B. Anschlusspads sind, erstrecken sich durchgehend von der Vorderseite bis zur Rückseite der flexiblen Leiterplatte, und berühren somit den an der Rückseite der flexiblen Leiterplatte vorgesehenen bzw. angespritzten Kühlkörper unmittelbar. Hierfür ist ein elektrisch isolierend ausgebildeter Kühlkörper insbesondere von Vorteil.

Wie bereits angemerkt, werden die leitenden Bereiche der flexiblen Leiterplatte üblicherweise aus Kupfer gebildet, d.h. aus einem thermisch und elektrisch gut leitfähigen Material, so dass die durch die Leuchtdiode abgestrahlte Wärme besonders effizient über die leitenden Bereiche unmittelbar an dem Kühlkörper abgegeben werden kann.

Vorzugsweise ist die flexible Leiterplatte aus einem der folgenden Materialien gebildet bzw. umfasst die flexible Leiterplatte im Wesentlichen eines der folgenden Materialien: Polyethylennaphtalat, Polyester und/oder Polyimid. Insbesondere ist es von Vorteil, wenn die flexible Leiterplatte aus Polyimid (oder einem vergleichbaren duroplastischen Polymer) gebildet ist bzw. im Wesentlichen aus Polyimid besteht. Denn Polyimid weist eine besonders hohe Temperaturbestätigkeit auf, die notwendig ist, damit die flexible Leiterplatte mit dem flüssigen, heißen Kunststoff in Berührung kommen kann, ohne dass dadurch die flexible Leiterplatte beschädigt oder zerstört wird. Polyimid kann dabei kurzzeitig Temperaturen von bis zu 400°C ausgesetzt werden, ohne dass dadurch das Material beschädigt wird.

Zur exakten Positionierung der flexiblen Leiterplatte in der Aufnahme des Gusswerkzeugs eignet sich insbesondere eine Fixierung durch ein Polyimid-Klebeband, das den Gussprozess nicht nachteilig beeinträchtigt und darüber hinaus die hohen Gusstemperaturen übersteht. Alternativ kann die flexible Leiterplatte mittels einer Vakuum- bzw. Unterdruckhaltevorrichtung, einer Klemmvorrichtung oder mittels einer elektrostatischen Haltevorrichtung in der Aufnahme des Gusswerkzeugs befestigt werden.

Die Erfindung betrifft ferner eine Leiterplatten-Anordnung nach Anspruch 12, aufweisend eine flexible Leiterplatte mit leitenden Bereichen sowie einen mit der flexiblen Leiterplatte direkt versehenene bzw. hinterspritzten Kunststoff-Kühlkörper. Wenigstens ein Teil der leitenden Bereiche ist zur thermischen Kontaktierung der flexiblen Leiterplatte mit dem Kühlkörper durchgehend von der Vorderseite zu der den Kühlkörper aufweisenden Rückseite der flexiblen Leiterplatte vorgesehen, um direkt mit dem Kühlkörper in Kontakt zu stehen. Die leitenden Bereiche der flexiblen Leiterplatte sind Leiterbahnen und/oder elektrische Kontaktierungen.

Ferner betrifft die Erfindung ein Beleuchtungsmittel nach Anspruch 13, umfassend eine erfindungsgemäße Leiterplatten-Anordnung sowie ferner Leuchtmittel, wie insbesondere Leuchtdioden, welche vorzugsweise auf der dem Kühlkörper abgewandten Seite der flexiblen Leiterplatte mit den leitenden Bereichen (also bspw. Anschlusspads) elektrisch kontaktiert sind.

### 4. Beschreibung einer bevorzugten Ausführungsform

Nachfolgend wird eine detaillierte Beschreibung der Figuren gegeben, in dieser zeigt:
- Figur 1: eine schematische Querschnittsansicht einer flexiblen Leiterplatte;
- Figur 2: eine Draufsicht auf eine flexible Leiterbahn;
- Figur 3: eine Rückseite der flexiblen Leiterbahn aus Figur 2;
- Figur 4: die flexible Leiterplatte aus Figur 1, bestückt mit Leuchtdioden (Beleuchtungsmittel);
- Figur 5: eine erfindungsgemäße Leiterplatten-Anordnung hergestellt durch ein erfindungsgemäßes Verfahren;
- Figur 6: eine schematische Ansicht der erfindungsgemäßen Leiterplatten-Anordnung (Beleuchtungsmittel); und
- Figur 7: ein weiteres Ausführungsbeispiel einer erfindungsgemäßen Leiterplatten-Anordnung (Beleuchtungsmittel) mit 3D-förmiger Ausgestaltung.

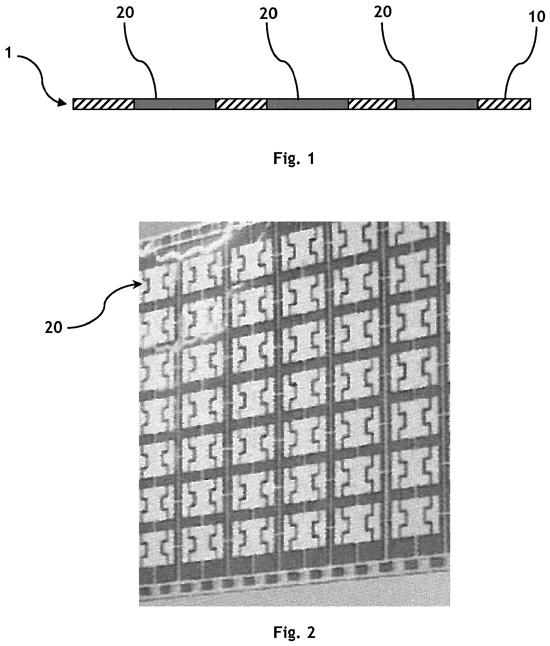

Figur 1 zeigt eine schematische Querschnittsansicht einer flexiblen Leiterplatte 1, die in der gezeigten Ausführungsform drei Anschlusspads für Leuchtdioden mit korrespondierenden Leiterbahnen 20 aufweist.

In der gezeigten bevorzugt Ausführungsform umfasst die flexible Leiterplatte 1 ein Trägermaterial 10 aus Polyimid, das die gewünschte hohe Flexibilität und Temperaturbeständigkeit aufweist.

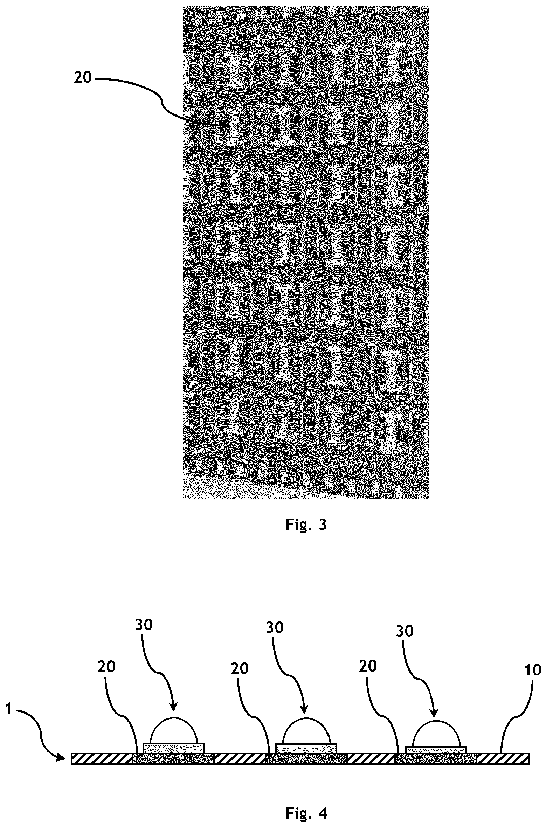

Figur 2 zeigt eine Draufsicht auf eine flexible Leiterplatte 1**.** In Figur 2 besonders gut zu erkennen sind die jeweiligen elektrisch (und/oder thermisch) leitenden Bereiche 20, hier Leiterbahnen und elektrische Kontaktierungen (beispielsweise Anschlusspads für Leuchtdioden) sowie thermische Kontaktierungen. Figur 3 zeigt die Rückseite der in Figur 2 gezeigten flexiblen Leiterplatte 1**.** Dabei ist in Figur 3 zu erkennen, dass die elektrisch und/oder thermisch leitenden Bereiche 20 (also die vorwiegend thermischen Kontaktierungen) durchgehend, d.h. von der Vorderseite der flexiblen Leiterplatte 1 bis zur Rückseite der flexiblen Leiterplatte 1, ausgebildet sind. Alternativ können noch weitere durchgehende leitende Bereiche 20 vorgesehen werden, um die thermische Leitfähigkeit zu erhöhen. Unter "leitende Bereiche" werden erfindungsgemäße insbesondere elektrisch leitende Bereiche verstanden, die vorwiegend (insbesondere die Durchkontaktierungen) auch eine besonders gute thermische Leitfähigkeit besitzen.

Figur 4 zeigt die flexible Leiterplatte 1 aus Figur 1, bestückt mit Leuchtdioden 30.

Wie in den Figuren 1 bis 4 gut zu erkennen, sind die Leiterbahnen und Anschlusspads 20 der flexiblen Leiterplatte 1 durchgehend. Die Leiterbahnen und Anschlusspads 20 bestehen dabei vorliegend aus einer Kupferlegierung.

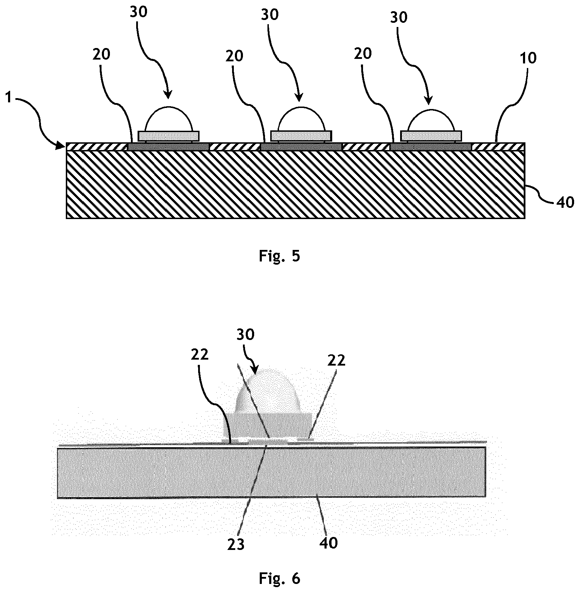

Figur 5 zeigt eine schematische Querschnittsansicht einer erfindungsgemäßen Leiterplatten-Anordnung, die mit einem erfindungsgemäßen Verfahren hergestellt wurde. Die gezeigte Leiterplatten-Anordnung weist elektronische Bauteile auf, die auf den elektrischen Kontaktierungen aufgebracht sind. Im Falle von Leuchtmitteln, bspw. Leuchtdioden 30, als elektronische Bauteile wird die Leiterplatten-Anordnung im Rahmen der Erfindung auch als Beleuchtungsmittel bezeichnet.

Wie in Figur 5 gut zu erkennen, kontaktiert ein Kühlkörper 40, der aus Kunststoff mit einem Füllstoff zur Erhöhung der thermischen Leitfähigkeit besteht, unmittelbar die Rückseite der flexiblen Leiterplatte 1, und damit unmittelbar die durch die flexible Leiterplatte hindurchgehenden Leiterbahnen und Anschlusspads 20. Dadurch wird die beispielsweise von den Leuchtdioden 30 auftretende Wärme optimal durch die Leiterbahnen und Anschlusspads 20 zum Kühlkörper 40 geführt.

Zur Herstellung einer Leiterplatten-Anordnung, wie sie in Figur 5 gezeigt ist, wird wie folgt vorgegangen:
Zunächst wird entweder die in Figur 1 gezeigte flexible Leiterplatte 1 ohne bestückte Leuchtdioden oder die in Figur 4 gezeigte flexible Leiterplatte 1 mit bestückten Leuchtdioden 30 in ein Gusswerkzeug (vorzugsweise ein Spritz- oder Druckgusswerkzeug), das eine spezielle Aufnahme für die flexible Leiterplatte 1 aufweist, eingelegt.

Eine Befestigung der flexiblen Leiterplatte 1 in der Aufnahme des Gusswerkzeugs kann mittels eines Klebebands beispielsweise auf Polyimidbasis erfolgen. Alternativ kann die flexible Leiterplatte beispielsweise auch mittels einer Vakuum- bzw. Unterdruckhaltevorrichtung, einer Klemmvorrichtung oder mittels einer elektrostatischen Haltevorrichtung in der Aufnahme des Gusswerkzeugs befestigt werden.

Im nachfolgenden Verfahrensschritt wird (thermo- oder duroplastischer) Kunststoff in das Gusswerkzeug, das eine Gusskavität für den in Figur 3 gezeigten Kühlkörper 40 aufweist, eingebracht; also beispielsweise eingespritzt (beim Spritzgussverfahren) oder eingedrückt (beim Druckgussverfahren).

Dem eingespritzten bzw. eingebrachten Kunststoff ist dabei vorzugsweise ein aluminiumhaltiger Füllstoff beigemengt, durch den in Abhängigkeit der Füllstoffmenge die thermische Leitfähigkeit des Kühlkörpers 40 eingestellt werden kann. Der Kunststoff wird dabei in Abhängigkeit der Füllstoffmenge mit einer Temperatur zwischen 250 und 400°C in das Gusswerkzeug bzw. in die Gusskavität eingebracht bzw. eingespritzt.

Durch das Einbringen bzw. Einspritzen des Kunststoffs und durch die entsprechende Positionierung der flexiblen Leiterplatte 1 im Gusswerkzeug kann der Kühlkörper 40 somit unmittelbar an der Rückseite der flexiblen Leiterplatte 1 angeformt werden; vorzugsweise derart, dass dieser die durch die flexible Leiterplatte 1 durchgehenden leitenden Bereiche 20 der flexiblen Leiterplatte 1 unmittelbar kontaktiert.

Durch das erfindungsgemäße Verfahren ist es also möglich, einen Kühlkörper unmittelbar an einer flexiblen Leiterplatte anzuordnen, ohne dabei die im Stand der Technik notwendigen Verfahrensschritte des Aufklebens oder Auflaminierens der flexiblen Leiterplatte auf einem Kühlkörper durchführen zu müssen, und dabei eine Leiterplatten-Anordnung bereitstellen zu können, die einen effizienten Wärmeabtransport von der Leuchtdiode hin zum Kühlkörper ermöglicht.

Figur 6 zeigt eine schematische Ansicht der erfindungsgemäßen Leiterplatten-Anordnung (Beleuchtungsmittel) mit flexibler Leiterplatte 1, auf der ein elektronisches Bauteil (vorliegend eine Leuchtdiode 30) über Anschlusspads 22 elektrisch kontaktiert ist, wobei der leitende Bereich ferner eine thermische (Durch-) Kontaktierung 23 zur effizienten Wärmeabfuhr auf den vorzugsweise rückseitig der flexiblen Leiterplatte 1 vorgesehenen Kühlkörper 40 aufweist. Letzterer besteht vorzugsweise aus einem thermisch hoch-leitfähigem Kunststoff.

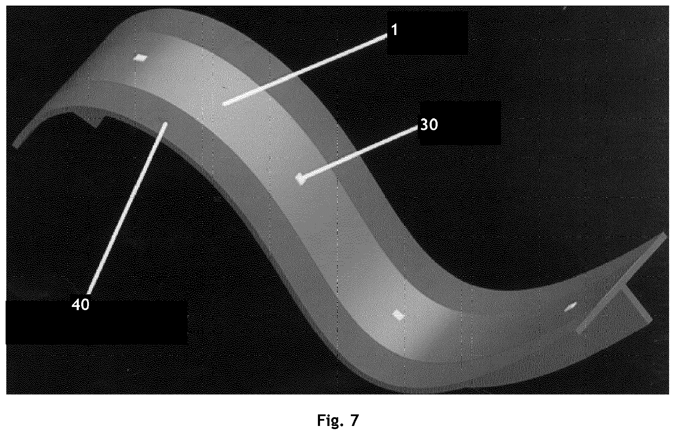

Figur 7 zeigt ein weiteres Beispiel einer erfindungsgemäßen Leiterplatten-Anordnung (Beleuchtungsmittel) mit 3D-förmiger Ausgestaltung, in der die mit Leuchtdioden 30 bestückte Leiterplatte 1 in komplexer Anordnung auf einfache Weise mit einem entsprechend komplex gestalteten Kühlkörper 40 versehen bzw. hinterspritzt ist.

Es ist darauf hinzuweisen, dass die vorliegende Erfindung nicht beschränkt ist auf Leiterplatten-Anordnungen zur Aufnahme von Leuchtdioden bzw. auf die Anwendung in einem Beleuchtungsmittel, sondern es für den Fachmann erkennbar ist, dass die vorliegende Erfindung allgemein dort eingesetzt werden kann, wo flexible Leiterplatten mit einem Kühlkörper versehen werden. Mit anderen Worten in Anwendungen, wo von einer flexiblen Leiterplatte Wärmeenergie durch einen Kühlkörper abgeführt werde soll.

## Patentansprüche

1. Verfahren zur Herstellung einer Leiterplatten-Anordnung, wobei das Verfahren die folgenden Schritte umfasst:
- Bereitstellen zumindest einer flexiblen Leiterplatte (1), umfassend leitende Bereiche (20);
- Bereitstellen eines Gusswerkzeugs, vorzugsweise eines Spritz- oder Druckgusswerkzeugs, das zumindest eine Aufnahme für die zumindest eine flexible Leiterplatte (1) und zumindest eine Gusskavität zur Ausbildung eines Kühlkörpers (40) umfasst;
- Einlegen der flexiblen Leiterplatte (1) in die Aufnahme des Gusswerkzeugs; und
- Einbringen von Kunststoff in das Gusswerkzeug, so dass der Kühlkörper (40) direkt an zumindest einer Seite der eingelegten flexiblen Leiterplatte (1) gebildet wird;
- wobei wenigstens ein Teil der leitenden Bereiche (20) zur thermischen Kontaktierung der flexiblen Leiterplatte (1) durchgehend von der Vorderseite zu der den Kühlkörper (40) aufweisenden Rückseite der flexiblen Leiterplatte (1) vorgesehen ist, um direkt mit dem Kühlkörper in Kontakt zu stehen;
- wobei die leitenden Bereiche (20) Leiterbahnen (20) und/oder elektrische Kontaktierungen sind und durchgehend von der Vorderseite bis zur Rückseite der flexiblen Leiterplatte (1) ausgebildet sind und die Leiterbahnen (20) und/oder die elektrischen Kontaktierungen (20) den gebildeten Kühlkörper (40) unmittelbar kontaktieren.

2. Verfahren nach Anspruch 1, wobei der Kunststoff einen Füllstoff zur Erhöhung der thermischen Leitfähigkeit des Kühlkörpers (40) umfasst, wobei der Füllstoff zur Erhöhung der thermischen Leitfähigkeit vorzugsweise zumindest eine der folgenden Bestandteile umfasst: Kupfer, Aluminium, Graphit, Ruß, Al₂O₃, AlN, BN.

3. Verfahren nach einem der vorhergehenden Ansprüche, wobei der thermisch leitfähige Kunststoff eine Wärmeleitfähigkeit zwischen 1 und 15 W/mK, bevorzugt zwischen 2 und 10 W/mK und besonders bevorzugt zwischen 4 und 6 W/mK aufweist.

4. Verfahren nach einem der vorhergehenden Ansprüche, wobei die flexible Leiterplatte (1) vor dem Einlegen in die Aufnahme des Gusswerkzeugs mit zumindest einer Leuchtdiode (30) bestückt wird.

5. Verfahren nach einem der vorhergehenden Ansprüche, wobei die Leuchtdiode (30) eine Hochleistungs-Leuchtdiode ist, die eine Leistungsaufnahme von wenigstens 300 mW aufweist, bevorzugt zwischen 1 und 3 W.

6. Verfahren nach einem der vorhergehenden Ansprüche, wobei der Kühlkörper (40) an der Rückseite der flexiblen Leiterplatte (1) gebildet wird.

7. Verfahren nach einem der vorhergehenden Ansprüche, wobei der gebildete Kühlkörper (40) elektrisch isolierend ausgebildet ist.

8. Verfahren nach einem der vorhergehenden Ansprüche, wobei die leitenden Bereiche (20) Anschlusspads (20) der flexiblen Leiterplatte (1) sind.

9. Verfahren nach einem der vorhergehenden Ansprüche, wobei die flexible Leiterplatte (1) wenigstens eines der folgenden Materialen umfasst:
Polyethylennaphtalat, Polyester, Polyimid.

10. Verfahren nach einem der vorhergehenden Ansprüche, wobei die flexible Leiterplatte (1) mittels eines Klebebandes in der Aufnahme des Gusswerkzeugs befestigt wird, wobei das Klebeband vorzugsweise Polyimid umfasst.

11. Verfahren nach einem der vorhergehenden Ansprüche, wobei der Kunststoff mit einer Temperatur zwischen 250 und 400 °C, bevorzugt zwischen 280 und 380 °C und besonders bevorzugt zwischen 300 und 320°C in das Gusswerkzeug eingebracht, insbesondere eingespritzt wird.

12. Leiterplatten-Anordnung, aufweisend eine flexible Leiterplatte (1) mit leitenden Bereichen (20) sowie einen mit der flexiblen Leiterplatte (1) direkt versehenen, insbesondere hinterspritzten Kunststoff-Kühlkörper (40), **dadurch gekennzeichnet, dass** wenigstens ein Teil der leitenden Bereiche (20) zur thermischen Kontaktierung der flexiblen Leiterplatte (1) durchgehend von der Vorderseite zu der den Kühlkörper (40) aufweisenden Rückseite der flexiblen Leiterplatte (1) vorgesehen ist, um direkt mit dem Kühlkörper in Kontakt zu stehen, wobei die leitenden Bereiche (20) Leiterbahnen (20) und/oder elektrische Kontaktierungen sind und durchgehend von der Vorderseite bis zur Rückseite der flexiblen Leiterplatte (1) ausgebildet sind und die Leiterbahnen (20) und/oder die elektrischen Kontaktierungen (20) den gebildeten Kühlkörper (40) unmittelbar kontaktieren.

13. Beleuchtungsmittel, umfassend eine Leiterplatten-Anordnung nach Anspruch 12, ferner aufweisend Leuchtmittel, wie insbesondere Leuchtdioden (30), welche vorzugsweise auf der dem Kühlkörper (40) abgewandten Seite der flexiblen Leiterplatte (1) mit den leitenden Bereichen (20) elektrisch kontaktiert sind.

## Claims

1. Method for producing a circuit board assembly, wherein said method comprises the following steps:
- providing at least one flexible circuit board (1) comprising conductive regions (20);
- providing a casting tool, preferably an injection molding or die casting tool, which comprises at least one receptacle for the at least one flexible circuit board (1) and at least one casting cavity for forming a heat sink (40);
- inserting the flexible circuit board (1) into the receptacle of the casting tool; and
- introducing plastic into the casting tool so that the heat sink (40) is formed directly on at least one side of the inserted flexible circuit board (1);
- wherein at least a portion of the conductive regions (20) for thermally contacting the flexible circuit board (1) are provided continuously from the front side to the rear side of the flexible circuit board (1) comprising the heat sink (40) in order to be in direct contact with the heat sink;
- wherein the conductive regions (20) are strip conductors (20) and/or electrical contacts and are configured continuously from the front side to the rear side of the flexible circuit board (1) and the strip conductors (20) and/or the electrical contacts (20) are in direct contact with the formed heat sink (40) .

2. Method according to Claim 1, wherein the plastic comprises a filler for increasing the thermal conductivity of the heat sink (40), wherein the filler for increasing the thermal conductivity preferably comprises at least one of the following constituents: copper, aluminum, graphite, carbon black, Al₂O₃, AlN, BN.

3. Method according to any one of the preceding claims, wherein the thermally conductive plastic has a thermal conductivity between 1 and 15 W/mK, preferably between 2 and 10 W/mK, and particularly preferably between 4 and 6 W/mK.

4. Method according to any one of the preceding claims, wherein the flexible circuit board (1) is fitted with at least one light-emitting diode (30) prior to insertion into the receptacle of the casting tool.

5. Method according to any one of the preceding claims, wherein the light-emitting diode (30) is a high-power light-emitting diode which has a power consumption of at least 300 mW, preferably between 1 and 3 W.

6. Method according to any one of the preceding claims, wherein the heat sink (40) is formed on the rear side of the flexible circuit board (1).

7. Method according to any one of the preceding claims, wherein the formed heat sink (40) is electrically insulating.

8. Method according to any one of the preceding claims, wherein the conductive regions (20) are connection pads (20) of the flexible circuit board (1).

9. Method according to any one of the preceding claims, wherein the flexible circuit board (1) comprises at least one of the following materials: polyethylene naphthalate, polyester, polyimide.

10. Method according to any one of the preceding claims, wherein the flexible circuit board (1) is fastened in the receptacle of the casting tool using adhesive tape, wherein the adhesive tape preferably comprises polyimide.

11. Method according to any one of the preceding claims, wherein the plastic is introduced, in particular injected, into the casting tool at a temperature between 250 and 400°C, preferably between 280 and 380°C, and particularly preferably between 300 and 320°C.

12. Circuit board assembly, comprising a flexible circuit board (1) having conductive regions (20) and a plastic heat sink (40) which is provided directly, in particular back-molded, with the flexible circuit board (1), **characterized in that** at least a portion of the conductive regions (20) for thermally contacting the flexible circuit board (1) are provided continuously from the front side to the rear side of the flexible circuit board (1) comprising the heat sink (40) in order to be in direct contact with the heat sink, wherein the conductive regions (20) are strip conductors (20) and/or electrical contacts and are configured continuously from the front side to the rear side of the flexible circuit board (1) and the strip conductors (20) and/or the electrical contacts (20) are in direct contact with the formed heat sink (40).

13. Illuminating means comprising a circuit board assembly according to Claim 12, further comprising lighting means, in particular light-emitting diodes (30), which are preferably in electrical contact with the conductive regions (20) on the side of the flexible circuit board (1) facing away from the heat sink (40).

## Revendications

1. Procédé de fabrication d'un ensemble de circuit imprimé, ledit procédé comprenant les étapes suivantes :
- mise à disposition d'au moins une carte de circuit imprimé flexible (1) comprenant des zones conductrices (20),
- mise à disposition d'un outil de moulage, de préférence de moulage par injection ou sous pression, comprenant au moins un logement destiné à l'au moins une carte de circuit imprimé flexible (1) et au moins une cavité de moulage servant à la formation d'un dissipateur thermique (40),
- disposition de la carte de circuit imprimé flexible (1) dans le logement de l'outil de moulage, et
- introduction de matière plastique dans l'outil de moulage de manière à former directement le dissipateur thermique (40) sur au moins une face de la carte de circuit imprimé flexible (1) disposée dans l'outil ;
- au moins une partie des zones conductrices (20) étant prévue pour une mise en contact thermique traversante de la carte de circuit imprimé flexible (1), depuis la face avant de ladite carte de circuit imprimé flexible (1) jusqu'à sa face arrière présentant ledit dissipateur thermique (40), pour un contact direct avec ledit dissipateur thermique ;
- lesdites zones conductrices (20) consistant en des pistes conductrices (20) et/ou des contacts électriques et étant formées de manière traversante, depuis la face avant jusqu'à la face arrière de la plaque de circuit imprimé flexible (1), et lesdites pistes conductrices (20) et/ou lesdits contacts électriques (20) étant directement en contact avec ledit dissipateur thermique (40) formé.

2. Procédé selon la revendication 1, dans lequel la matière plastique comprend une charge visant à augmenter la conductivité thermique du dissipateur thermique (40), ladite charge visant à augmenter la conductivité thermique comprenant au moins l'un des composants suivants : cuivre, aluminium, graphite, noir de carbone, Al₂O₃, AlN, BN.

3. Procédé selon l'une des revendications précédentes, dans lequel la matière plastique thermiquement conductrice présente une conductivité thermique comprise entre 1 et 15 W/mK, de préférence entre 2 et 10 W/mK et tout préférablement entre 4 et 6 W/mK.

4. Procédé selon l'une des revendications précédentes, dans lequel la plaque de circuit imprimé flexible (1) est équipée d'au moins une diode électroluminescente (30) avant sa disposition dans le logement de l'outil de moulage.

5. Procédé selon l'une des revendications précédentes, dans lequel la diode électroluminescente (30) est une diode électroluminescente de forte puissance présentant une consommation d'énergie d'au moins 300 mW, de préférence entre 1 et 3 W.

6. Procédé selon l'une des revendications précédentes, dans lequel le dissipateur thermique (40) est formé sur la face arrière de la carte de circuit imprimé flexible (1).

7. Procédé selon l'une des revendications précédentes, dans lequel le dissipateur thermique (40) formé est de conception électriquement isolante.

8. Procédé selon l'une des revendications précédentes, dans lequel les zones conductrices (20) sont des plages d'accueil (20) de la carte de circuit imprimé flexible (1).

9. Procédé selon l'une des revendications précédentes, dans lequel la carte de circuit imprimé souple (1) comprend au moins un des matériaux suivants : naphtalate de polyéthylène, polyester, polyimide.

10. Procédé selon l'une des revendications précédentes, dans lequel la plaque de circuit imprimé flexible (1) est fixée dans le logement de l'outil de moulage au moyen d'un ruban adhésif, lequel ruban adhésif comprend de préférence du polyimide.

11. Procédé selon l'une des revendications précédentes, dans lequel la matière plastique est introduite, de préférence injectée, dans l'outil de moulage à une température comprise entre 250 et 400°C, de préférence entre 280 et 380°C et tout préférablement entre 300 et 320°C.

12. Ensemble de circuit imprimé présentant une carte de circuit imprimé flexible (1) pourvue de zones conductrices (20) ainsi qu'un dissipateur thermique (40) en matière plastique directement doté de la carte de circuit imprimé flexible (1) et notamment formé par injection sur celle-ci ; **caractérisé en ce qu'**au moins une partie des zones conductrices (20) est prévue pour une mise en contact thermique traversante de la carte de circuit imprimé (1), depuis la face avant de ladite carte de circuit imprimé (1) jusqu'à sa face arrière présentant le dissipateur thermique (40), pour un contact direct avec ledit dissipateur thermique, lesdites zones conductrices (20) consistant en des pistes conductrices (20) et/ou des contacts électriques et étant formées de manière traversante, depuis la face avant jusqu'à la face arrière de la plaque de circuit imprimé flexible (1), et lesdites pistes conductrices (20) et/ou lesdits contacts électriques (20) étant directement en contact avec ledit dissipateur thermique (40) formé.

13. Équipement d'éclairage comprenant un ensemble de circuit imprimé selon la revendication 12 et présentant en outre des moyens luminescents tels que des diodes électroluminescentes (30) qui sont de préférence mises en contact électrique avec les zones conductrices (20) sur la face de la carte de circuit imprimé flexible (1) qui est détournée du dissipateur thermique (40) .
